Europäisches Patentamt

European Patent Office

Office européen des brevets

(19)

(11) Veröffentlichungsnummer: **0 225 559 B1**

## (12) EUROPÄISCHE PATENTSCHRIFT

(45) Veröffentlichungstag der Patentschrift:
**05.06.91 Patentblatt 91/23**

(51) Int. Cl.$^5$: **H01L 27/14,** H01L 27/146,
H04N 1/028

(21) Anmeldenummer: **86116561.1**

(22) Anmeldetag: **28.11.86**

(54) **Kontaktbildsensorzeile.**

(30) Priorität: **13.12.85 DE 3544182**

(43) Veröffentlichungstag der Anmeldung:
**16.06.87 Patentblatt 87/25**

(45) Bekanntmachung des Hinweises auf die
Patenterteilung:
**05.06.91 Patentblatt 91/23**

(84) Benannte Vertragsstaaten:
**DE FR GB NL**

(56) Entgegenhaltungen:
**EP-A- 0 037 244**
**EP-A- 0 075 695**
**DE-A- 3 345 239**
**DE-A- 3 432 185**
**GB-A- 2 044 996**
**US-A- 4 303 936**

(73) Patentinhaber: **Heimann GmbH**
**Weher Köppel 6 Postfach 30 07**
**W-6200 Wiesbaden 1 (DE)**

(72) Erfinder: **Traupe, Ulrich, Dipl.-Phys.**
**Eltviller Strasse 6**
**W-6200 Wiesbaden (DE)**
Erfinder: **Dennhoven, Manfred, Dipl.-Ing.**
**Kastanienweg 13**
**W-5421 Osterspai (DE)**
Erfinder: **Heimann, Bernd, Dr.**
**Thomaestrasse 5**
**W-6200 Wiesbaden (DE)**

(74) Vertreter: **Fuchs, Franz-Josef, Dr.-Ing. et al**
**Postfach 22 13 17**
**W-8000 München 22 (DE)**

## Beschreibung

Die Erfindung betrifft ein Verfahren zur Herstellung einer Kontaktbildsensorzeile gemäß dem ersten Teil des Patentanspruches.

Kontaktbildsensorzeilen ermöglichen das Lesen einer optischen Information eines Textes oder einer Graphik, das Wandeln in eine analoge elektrische Information, die anschließende Wandlung in eine digitale elektrische Information und damit das Sortieren und Speichern der Information. Die digital geordnete und gespeicherte Information kann dann in bekannter Weise für alle Formen der Bildverarbeitung und Bildwiedergabe (z.B. Fernkopierer, Bildschirmwiedergabe) nutzbar gemacht werden.

Bisher wurde dieses Problem durch Zeilensensoren mit Vorschub senkrecht zur Zeilenachse gemäß den folgenden Funktionsprinzipien gelöst :

a) durch Abbildung einer Vorlage mit einer Verkleinerungsoptik auf CCD-Zeilen mit einer Länge von z.B. 22,5 mm. Nachteile sind dabei die geringe Schärfentiefe des Abbildungsstrahlenganges, dadurch extreme Justieranforderungen an das Gerät und hoher Raumbedarf für den Strahlengang.

b) durch 1 : 1-Abbildung mitteln Grin (gradient index)-Faseroptiken auf eine Anordnung von CCD-Zeilen mit jeweils etwa 6 cm Länge. Dabei ergeben sich folgende Nachteile : Die CCD's müssen mit möglichst großer Länge und damit großer Fläche hergestellt werden, um die Vorteile des CCD-Prinzips nutzen zu können. Durch das Schieben der elektrischen Ladungen in den CCD's über Distanzen von 6 cm entstehen jedoch hohe Ladungsverluste. Außerdem können CCD-Chips mit einer derart großen Fläche (z.B. 65 × 5 mm² = 325 mm²) nicht in absehbarer Zeit mit genügend hoher Ausbeute, d.h. zu vertretbaren Preisen hergestellt werden, zumal es keine Möglichkeit der Ausbeuteverbesserung durch Einbau von Redundanzen gibt.

c) durch 1 : 1-Abbildung mittels Grinfaseroptiken auf Sensorzeilen aus einem Photoleitermaterial, z.B. a-Si : H. Die bisher verwendeten Sensorzeilen bestehen aus einer linearen Anordnung von Photoleiterzellen z.B. auf der Basis von a-Si : H, mit 8, 12 oder 16 Bildpunkten/mm und einer Anordnung von Auslese- und Signalaufbereitungselementen. Die Auslese- und Signalaufbereitungselemente sind in monokristalliner Technik ausgeführt. Die Verbindung zwischen den Sensoren und den Auslese- und Signalaufbereitungselementen er folgt durch Drähte und Leiterbahnen.

Für die Ansteuerung der einzelnen Sensoren und die Signalaufbereitung werden die beiden folgenden Prinzipien angewandt :

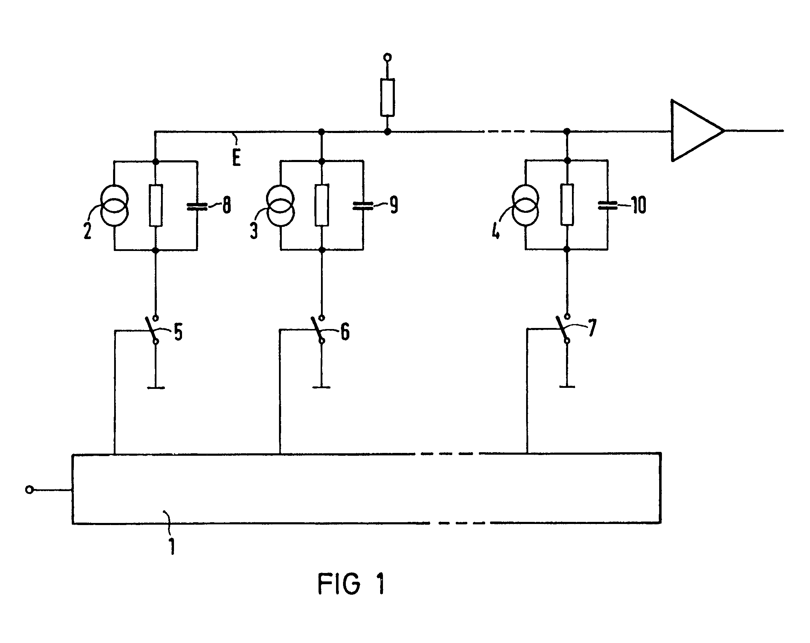

Auslesen nach dem Vidiconprinzip (siehe Figur 1).

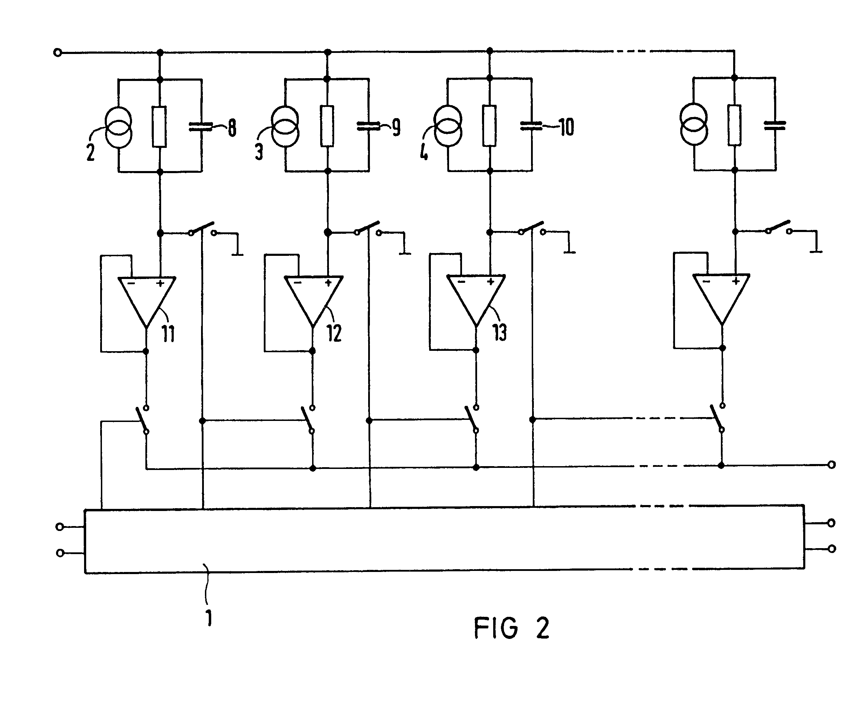

Messung der Spannung an der lichtempfindlichen Zelle (siehe Figur 2).

Bei beiden Prinzipien wird mit Hilfe eines Schieberegisters 1 seriell jeder einzelne Sensor 2, 3, 4 angesteuert. Ein einzelner, einem Bildpunkt zugeordneter Sensor stellt eine Stromquelle mit Parallelkapazität dar. Bei der Anordnung mit der Auslesung nach dem Vidiconprinzip (Fig. 1) ist eine Elektrode E allen lichtempfindlichen Sensoren 2, 3, 4 gemeinsam. Durch das Schließen eines Schalters 5, 6, 7 nach einer Integrationszeit wird der entsprechende Sensor 2, 3, 4 in den Ausgangszustand zurückgesetzt. Der Strom, der in der gemeinsamen Elektrode E fließt, ist ein Maß für die vom entsprechenden Sensor absorbierte Lichtmenge. Danach beginnt durch Öffnen des Schalters 5, 6, 7 die nächste Integrationsphase des Sensors 2, 3, 4. Durch die Parallelschaltung aller Sensoren 2, 3, 4 wegen der gemeinsamen Elektrode E ist dem jeweils ausgelesenen Sensor 2, 3, 4 eine große Kapazität 8, 9, 10 parallel zugeordnet. Es er folgt eine kapazitive Signalteilung, die eine sehr hohe Nachverstärkung erfordert. Hierdurch wird ein schlechtes Signal-Rausch-Verhältnis erzielt.

Günstiger sind die Verhältnisse bei dem Prinzip der Messung der Spannung an den einzelnen lichtempfindlichen Sensoren 2, 3, 4 (analoge Signalaufbereitung). Mit Hilfe des Schieberegisters 1 wird gemäß Figur 2 der Entladezustand eines Sensors 2, 3, 4 nach der Integrationszeit an den gemeinsamen Signalausgang von Verstärkern 11, 12, 13, von denen für jeden Sensor 2, 3, 4 (Bildpunkt) jeweils einer vorhanden ist, weitergegeben. Sobald der Verstärker 11, 12, 13 des nächsten lichtempfindlichen Sensors 2, 3, 4 an den Ausgang angeschaltet wird, erfolgt die Rücksetzung des vorhergehenden Sensors in den Ausgangszustand und es beginnt eine neue Integrationsphase. Während dieser Zeit ändert sich die Spannung entsprechend

$$U(t) = U_o - \frac{i \cdot t}{C}$$

t : Integrationszeit

i : Strom im Sensor (proportional zur Beleuchtungsstärke)

C : Kapazität des Sensors plus der sonstigen Komponenten wie Verbindungsleitungen und Eingangskapazität des Verstärkers (Kapazitäten 8, 9, 10)

$U_o$ : Anfangsspannung.

Die Größe des Signalhubs ist neben der Beleuchtungsstärke und der Integrationszeit in starkem Maße von der Kapazität C abhängig. Wie aus der obigen Gleichung ersichtlich ist, wird der Signalhub mit geringerer Kapazität bei sonst unveränderten Parametern größer. Ein Ziel bei der Entwicklung einer Sensorzeile muß also die Minimierung der den einzelnen Sensoren parallel geschalteten Zusatzkapazitäten sein, die durch Leiterbahnen, Kontaktflächen, Eingang zur Signalauswertung, u.s.w. verursacht werden.

Eine Kontaktbildsensorzeile, bei der die Sensoren auf einem Substrat in einer Reihe angeordnet sind, ist in der DE-A-34 32 185 beschrieben. Ferner ist es durch die EP-A-0 037 244 bekannt, bei einem flächenhaften Bildwandler die Bildsensoren und diesen zugeordnete Schalttransistoren matrixartig als integrierte Schaltung auf einem Substrat aufzubauen.

Der Erfindung liegt die Aufgabe zugrunde, ein Verfahren zur Herstellung einer Kontaktbildsensorzeile gemäß dem ersten Teil des Patentanspruches zu schaffen, das eine Verkleinerung der zusätzlichen Kaparitäten ermöglicht.

Diese Aufgabe ist erfindungsgemäß durch den zweiten Teil des Patentanspruches gelöst.

Die Erfindung ist nachfolgend anhand der Zeichnungen näher erläutert.

Es zeigen :

Fig. 3 die wesentlichen Teile einer Kontaktbildsensorzeile im Schnitt,

Fig. 4 eine Anordnung mehrerer Kontaktbildsensorzeilen gemäß Fig. 3,

Fig. 5 eine Ansicht der Kontaktbildsensorzeile gemäß Fig. 3 von oben,

Fig. 6 einen Ansteuerbaustein mit MOS-Eingangsschutzstruktur in Aufsicht,

Fig. 7 ein Gerät zur optischen Abtastung einer Vorlage mit einer Kontaktbildsensorzeile gemäß Fig. 3, und

Fig. 8 eine Variante der Anordnung gemäß Fig. 4.

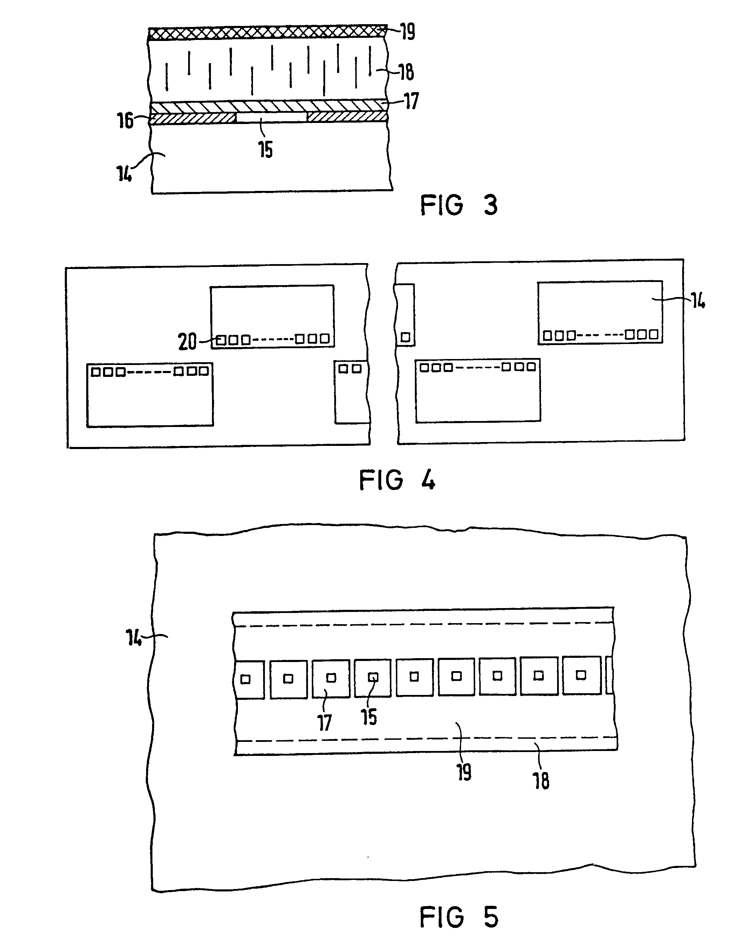

Fig. 3 zeigt einen Schnitt durch einen Bildpunkt einer Sensorzeile. Als Substrat dient der Ansteuerbaustein 14 in integrierter Schaltungstechnik. Darauf befindet sich für jeden Bildpunkt ein Kontakt 15. Zum Ausgleich und Glätten der Höhenstrukturen des Ansteuerbausteins 14 ist eine Isolatorschicht 16, z.B. aus Polyimid vorgesehen. Auf der Isolatorschicht 16, kontaktiert bei 15, befindet sich die Bildpunktgrundelektrode 17 z.B. aus Chrom, Titan oder Aluminium. Über der Grundelektrode 17 ist großflächig das Photoleiterschichtsystem 18 z.B. aus a-Si : H aufgebracht. Darüber befindet sich die transparente Deckelektrode 19 z.B. aus ITO.

Die Anordnung der Bildpunkte der Sensorzeile ist in Fig. 4 in der Aufsicht dargestellt mit den Ansteuerbausteinen 14 und darauf den Bildpunkten 20. Die Ansteuerbausteine 14 sind auf einem Substrat, z.B. aus Keramik oder Glas, angeordnet. Aus der Bildpunktanordnung ergeben sich zwei Bildpunktzeilen mit einem Abstand von z.B. 330 µm zueinander. Die Ansteuerbausteine 14 sind so gegeneinander versetzt angeordnet, daß entweder der erste Bildpunkt des Bausteins n + 1 in der Projektion auf die gemeinsame Zeilenachse den gleichen Abstand zum letzten Bildpunkt des Bausteins n wie zum zweiten Bildpunkt des Bausteins n + 1 hat, oder daß sich ein oder einige Bildpunkte der aufeinanderfolgenden Ansteuerbausteine 14 in der Projektion auf die gemeinsame Zeilenachse jeweils exakt überlagern. Die Ansteuerbausteine können z.B. jeweils 128 Bildpunkte haben. Eine Bildsensorzeile mit 12 Bildpunkten/mm hat dann 20 Ansteuerbausteine 14 mit insgesamt 2560 Bildpunkten. Es sind jedoch auch andere Bildpunktzahlen pro Ansteuerbaustein 14, andere Bildpunktortsfrequenzen und andere Zeilenlängen möglich.

In Fig. 5 ist der Aufbau der Bildpunkte auf einem Ansteuerbaustein 14 in der Aufsicht dargestellt. Die Isolationsschicht zur Oberflächenglättung des Ansteuerbausteins 14 wurde in der Darstellung aus Übersichtsgründen weggelassen. Die Kontakte 15 haben eine Kantenlänge von z.B. 5 µm. Die Bildpunktgrundelektroden 17 haben ein Rastermaß von z.B. 83 µm. Das Photoleitersichtsystem 18 und die durchsichtige Deckelektrode 19 sind als homogene Streifen ausgebildet. Die Dimensionierung der Bildpunktflächen erfolgt in diesem Beispiel durch die quadratischen Bildpunktgrundelektroden 17. Andere Arten der Bildpunktdimensionierung sind jedoch ebenfalls möglich.

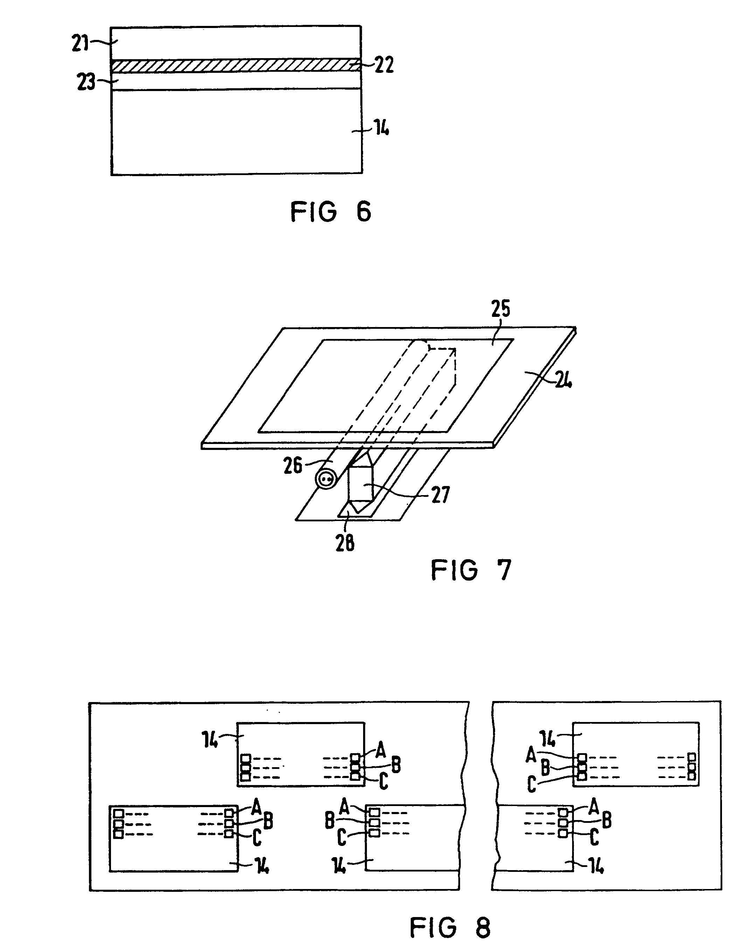

Gemäß Fig. 6 sind in Aufsicht die MOS-Eingangsschutzstrukturen 21 für die Bildpunktkontakte so angeordnet, daß sie bei der Prüfung der Ansteuerbausteine vorhanden und funktionsfähig sind und nach dem Aufbringen des Photoleiterschichtsystems entfernt werden. Hierdurch entfällt ein wesentlicher Teil der Kapazität am Eingang zur Signalaufbereitung. Eine Sägefuge ist in Fig. 6 mit 22 und eine Kurzschlußbeschichtung mit 23 bezeichnet.

Die Ansteuerbausteine 14 sind auf dem Wafer zunächst mit MOS-Eingangsschutzstrukturen 21 für die Bildpunktkontakte verbunden. Nach Prüfung der Ansteuerbausteine 14 auf dem Wafer werden diese Schutzstrukturen 21 durch die Kurzschlußbeschichtung 23 überbrückt. Danach werden die Ansteuerbausteine 14 so ausgesägt, daß die Eingangschutzstrukturen 21 jeweils vom zugehörigen Ansteuerbaustein 14 getrennt werden, die Kurzschlußbeschichtung 23 jedoch erhalten bleibt (siehe Fig. 6).

Nach Fertigstellung der Sensorzeile werden die Kurzschlußstruktur der Bildpunkteingänge wieder beseitigt (z.B. durch Laser-oder Photoätztechnik), die Ansteuerbausteine 14 ausgangsseitig kontaktiert und gemeinsam mit der Auswerteelektronik, der Beleuchtungs- und Abbildungseinrichtung zu einem Lesemodul (Fig. 7) zusammengebaut. In Fig. 7 ist 24 eine Glasplatte, auf der eine Vorlage 25 liegt, welche von einer Lampe 26 beleuchtet wird. Die Sensorzeile, der die Lichtinformation über eine Grinfaseroptik 27 zugeführt wird, ist mit 28 bezeichnet.

In der vorgeschlagenen Anordnung entfallen die Kapazitäten der Leiterbahnen, der Kontaktflächen und der MOS-Eingangsschutzstrukturen. Durch Wegfall dieser Zusatzkapazitäten wird der Signalspannungshub am hochohmigen Eingang zur Signalaufbereitung deutlich erhöht und so gegenüber den bisherigen Anordnungen bei gleicher Beleuchtung und Integrationszeit ein erhöhter Signal-Rausch-Abstand erreicht, der in bekannter Weise die Übertragung einer erhöhten Graustufenzahl ermöglicht.

Das Verbonden von Kontaktdrähten zwischen den Bildpunktelektroden und den Ansteuerbausteinen (bei 2560 Bildpunkten würden 5120 Bondpunkte benötigt) entfällt.

Da die Sensorzeilen auf den bereits positionierten Ansteuerbausteinen hergestellt werden, muß lediglich sichergestellt sein, daß die Kontakte 15 mit den Bildpunktgrundelektroden 17 elektrisch kontaktiert sind, d. h., die Kontakte 15 müssen innerhalb der Flächen der Bildpunktgrundelektroden 17 positioniert sein. Daraus ergibt sich bei Kantenlängen von 5 μm der Kontakte 9 und 83 μm der Bildpunktgrundelektroden 17 eine zugelassene Positionierungstoleranz der Ansteuerbausteine 14 von ± 35 μm. Das sind deutlich geringere Positionieranforderungen als bei der Problemlösung gemäß Abschnitt b beim Stand der Technik.

Statt einer Bildpunktreihe pro Ansteuerbaustein 14 können auch mehrere, z.B. drei Bildpunktreihen A, B, C, pro Ansteuerbaustein 14 angeordnet werden. Diese Anordnung zeigt Fig. 8. Der Abstand der Bildpunktreihen A, B, C richtet sich ausschließlich nach den Bedingungen des optischen Abbildungssystems. Mit der genannten Anordnung ist es möglich, durch zeilenweise farbige Abbildung oder Filterung eine Vorlage farbig zu lesen und zu verarbeiten. Die Anordnung muß nicht notwendigerweise drei Zeilen pro Ansteuerbaustein 14 besitzen. Es sind auch andere Zeilenzahlen und andere als zeilenförmige Farbkodierungen möglich. Wesentlich ist, daß bei Verwendung von mehreren Zeilen eine Farbverarbeitung mit höherer Bildpunktauflösung als bei Verwendung nur einer Sensorzeile möglich ist, und daß durch die Parallelauswertung der Farbauszüge keine Verlängerung der Lesezeit gegenüber schwarz-weiß-Auslesungen erforderlich ist.

Die Anordnung gemäß Fig. 8 kann ohne Farbkodierung auch zum beschleunigten schwarz-weiß-Auslesen einer Information benutzt werden, da mit dieser Anordnung bei gleicher Integrationszeit pro Zeile die Lesezeit pro Seite um den Faktor der zusätzlich vorhandenen Sensorzeile verkürzt wird. Für diese Anwendung ist allerdings ein diskontinuierlicher Zeilenvorschub notwendig.

**Ansprüche**

1. Verfahren zur Herstellung einer Kontaktbildsensorzeile zum Lesen einer optischen Information, wobei

– die Kontaftbildsensorzeile mehrere Ansteuerbausteine (14) aufweist, die in Reihe auf einem Träger angeordnet sind,

– jeder Ansteuerbaustein (14) als integrierte Schaltung ausgebildet ist und das Substrat für lichtelektrische Sensoren (17 bis 19) bildet, und

– die lichtelektrischen Sensoren jeweils in Reihe auf einer auf dem zugehörigen Ansteuerbaustein (14) befindlichen Isolatorschicht (16) aufgebracht und mit dem Ansteuerbaustein (14) kontaktiert sind, mit folgenden Schritten :

– für die Prüfung der Ansteuerbausteine (14) werden MOS-Eingangsschutzstrufturen (21) auf dem Wafer ausgebildet,

– nach Prüfung der Ansteuerbausteine (14) werden die Eingangsschutzstrufturen (21) durch eine Kurzschlußbeschichtung (23) überbrückt und vom zugehörigen Ansteuerbaustein (14) getrennt, wobei die Kurzschlußbeschichtung (23) auf dem Ansteuerbaustein (14) erhalten bleibt, und

– nach dem Aufbringen der Sensoren wird die Kurzschlußbeschichtung (23) beseitigt.

**Claims**

1. Method for the production of a contact image sensor line for reading optical information, in which :

– the contact image sensor line has several drive modules (14) which are arranged in a row on a support,

– each drive module (14) is constructed as an integrated circuit and forms the substrate for photoelectric sensors (17 to 19), and

– the photo-electric sensors are applied respectively in a row to an insulator layer (16) located on the associated drive module (14), and are in contact with the drive module (14),
with the following steps :

– for testing the drive modules (14), MOS input protective structures (21) are constructed on the wafer,

– after the testing of the drive modules (14), the input protective structures (21) are bridged by a short-circuit coating (23) and separated from the associated drive module (14), the short-circuit coating (23) being maintained on the drive module (14), and

– after the application of the sensors, the short-circuit coating (23) is removed.

**Revendications**

1. Procédé pour fabriquer une ligne de détecteurs d'image à contact pour lire une information optique, comportant plusieurs modules de commande (14), qui sont disposés suivant une rangée sur un support, et selon lequel chaque module de commande (14) est réalisé sous la forme d'un circuit intégré et forme le substrat pour des détecteurs photoélectriques (17 à 19), qui sont disposés suivant une rangée sur une couche isolante (16) située sur le module de commande (14) et sont placés en contact avec ce module de commande,
caractérisé par le fait

– que pour le contrôle des modules de commande (14), on forme des structures de protection d'entrée MOS (21) sur la pastille,

– qu'après le contrôle des modules de commande, on shunte les structures de protection d'entrée (21) par un revêtement de court-circuit (23) et on les déconnecte du module de commande associé (14), le revêtement de court-circuit (23) subsistant sur le module de commande (14), et

– qu'après le dépôt des détecteurs, on élimine le revêtement de court-circuit (23).

FIG 1

EP 0 225 559 B1

FIG 2

FIG 3

FIG 4

FIG 5

FIG 6

FIG 7

FIG 8